# EUROPEAN PATENT SPECIFICATION

(11) **EP 2 914 489 B1**
(45) Date of publication and mention of the grant of the patent: **08.08.2018**
(21) Application number: 12887655.4
(22) Date of filing: 31.10.2012
(51) Int. Cl.: C23C 4/08, F01D 5/28, B29C 70/00, C23C 4/18, C23C 24/04, C23C 14/34, C23C 14/58, B64C 23/00, B64D 15/12, B64D 45/00, B64D 45/02, B64C 11/20

(54) **A POROUS COATING APPLIED ONTO AN AERIAL ARTICLE**
AUF EINEM LUFTARTIKEL AUFGEBRACHTE PORÖSE BESCHICHTUNG
REVÊTEMENT POREUX APPLIQUÉ SUR UN OBJET AÉRIEN

(43) Date of publication of application: 09.09.2015
(73) Proprietor: SAAB AB, 581 88 Linköping (SE)
(72) Inventor: NORDIN, Pontus, S-587 25 Linköping (SE); HALLANDER, Per, S-582 16 Linköping (SE); BOHLIN, Jonas, S-582 37 Linköping (SE); HELLSTRÖM, Thomas, S-589 51 Linköping (SE)
(74) Representative: Zacco Sweden AB
(86) International application number: PCT/SE2012/051183
(87) International publication number: WO 2014/070051

(56) References cited:
- GB-A- 833 675
- US-A- 2 319 968
- US-A- 5 915 743
- US-A- 6 165 600
- US-A1- 2003 138 659
- US-A1- 2006 039 788
- US-A1- 2008 311 374
- US-A1- 2009 017 260
- US-A1- 2009 092 844
- US-A1- 2009 096 687
- US-A1- 2009 317 236
- US-A1- 2010 155 533
- US-A1- 2010 327 213
- US-A1- 2011 052 902
- US-A1- 2011 052 902
- US-A1- 2012 082 556
- US-A1- 2012 082 556
- ZHAO H ET AL: "The influence of coating compliance on the delamination of thermal barrier coatings", SURFACE AND COATINGS TECHNOLOGY, ELSEVIER, AMSTERDAM, NL, vol. 204, no. 15, 25 April 2010 (2010-04-25), pages 2432-2441, XP026938706, ISSN: 0257-8972, DOI: 10.1016/J.SURFCOAT.2010.01.018 [retrieved on 2010-03-06]
- P. Fauchais ET AL: "Thermal Sprayed Coatings Used Against Corrosion and Corrosive Wear" In: "Advanced Plasma Spray Applications", 21 March 2012 (2012-03-21), InTech, XP055216666, ISBN: 978-9-53-510349-3 DOI: 10.5772/34448, * page 29, paragraph 5 * * page 22, paragraph 4.4.5 - page 23 * * page 7, paragraph 2.2; figures 3, 4 *

## Description

### TECHNICAL FIELD

The present invention relates to an aerial article according to the preamble of claim 1. It also relates to a method for application of the coating according to claim 9. The invention relates to the aircraft industry and to aircraft service maintenance. The invention is not limited thereto, but could also be related to activities of commercial airline companies as well.

### BACKGROUND ART

Current aerodynamic technologies for aircraft wings, vertical/horizontal stabilizers etc., comprising aerial articles, such as leading edges, airfoils, fairings, are often manufactured of composite material. However, such airframes, wings, leading edges, etc. are lacking sufficient and effective erosion protection functionality that supports laminar airflow. This will result in turbulent airflow over the airfoil, increasing the fuel consumption of the aircraft. The current solutions comprise steps, gaps, uneven surfaces, fastener protrusions, etc. An eroded leading edge must be replaced or covered by erosion protection tapes for providing a smoother aerodynamic surface. In some cases metal plates are riveted onto the leading edge and rivet heads cause turbulent airflow over the airfoil.

Different types of protective coatings are used. Tapes or metal coatings can be adhered or adhesively bonded onto the leading edge. A problem with such solutions is that moisture trapped within the composite wing will after some time cause delamination or bond breakage of the adhered coatings. Also the use of known technique results in an unnecessary high weight of the airfoil.

Plastic articles and components could be coated with a thin layer of metal for different reasons. In the aircraft industry, such coatings are subject for ongoing development.

Modern aircraft skins are mainly made of said composites (fibres and cured resin interacting with each other). They are built with a technique partly different from traditional aircraft comprising aluminium skins. The object is to achieve an aircraft of lower weight than those of aluminum alloys. However, wings of aluminium are more resistant to rain erosion than wings made of composites. During use, aircraft are subject for intense temperature changes, freeze and thaw cycles. An aircraft encounters a large amount of water during its flight, such as rains, clouds, fog etc. The structural (and/or aerial) articles of the aircraft, such as airfoils, leading edges, etc., are also subjected to extreme condensation, wherein water condenses within the composite structure and being in some cases trapped within the interior. Furthermore, the aircraft also meets weather hazards such as lightning strikes, rain erosion etc. All these phenomena negatively affect the performance of the aircraft. Water trapped within the aerial structure makes the aircraft heavy. A lightning strike may damage the aerodynamic surface of the aircraft. Rain erosion damages the aerodynamic surface of the article so that turbulent airflow over the aerodynamic surface of the airfoil may occur, which increases the fuel consumption. Also moisture diffuses into the composite. Freezing and thawing out regularly of the composite material will thereby negatively affect the aerodynamic performance of a modern aircraft.

GB 833 675 discloses a metallic layer interleaved with insulating layers of composite for protecting the leading edge of a wing.

US 2012/0082556 discloses an airfoil made of a composite material. The airfoil is adapted for a gas turbine engine. A metallic coating is disposed on at least one portion of the airfoil's composite surface. The application of a metallic coating onto the composite shown in US 2012/0082556 solves the problem how to provide a durable adhesion between the composite and the metal covering of the leading edge. The solution presented provides a metallic coating of nanocrystalline metal.

WO 2009/046084 discloses a metal coating applied over an airfoil of composite material for forming a lighting protection system aiming to improve reliability of current systems.

US2009096687 discloses creating a missile for example by extruding and nitriding of a core and skins, wherein the density of the missile may be highest at the tip.

The object of the present invention is to provide an effective way of keeping the low weight of the aircraft, at the same time as the durability is high.

The object of the present invention is also to provide an aerial article that is cost-effective to use, having a low service cost for maintaining the erosion protection.

At the same time is it desirable to provide an aerial article, which can be used under extreme conditions, such as moisture diffusion (where moisture diffuses in the cured resin structure/composite of the structure), and which also can be used for meeting weather hazards such as lightning strikes, rain erosion etc., still providing a low fuel consumption of the aircraft.

The objective is thus to provide an aerial article, which comprises an erosion protective coating saving weight and fuel.

The object is thus to provide an aerial article, which over time long time maintain its smooth aerodynamic surface for promoting a natural laminar flow.

### SUMMARY OF THE INVENTION

This has been achieved by the aerial article defined in the introduction and being characterized by the features of the characterizing part of claim 1.

Suitably, the coating partly or entirely covers the composite skin, wherein the coating is of such continuous porosity or sufficient degree of porosity to form an open area (diffusion passage way) through the metallic coating so that moisture transportation is permitted from the composite skin to the aerodynamic surface of the coating, and of such low porosity that erosion protection of the composite skin still is achieved during said use.

Preferably, the coating is applied onto the composite skin over an area corresponding with the stagnation point of the leading edge, wherein the coating is of such high porosity that moisture transportation is permitted from the cured resin skin to the aerodynamic surface, and of such low porosity that erosion protection of the composite skin still is achieved during said use.

In such way is achieved that the moisture embedded within the composite can diffuse out from the composite skin without being trapped in the interface between the coating and the composite outer surface. The article can be used under extreme weather conditions at low temperatures and being subjected to ice crystals, hail and rain without any cavitation erosion from the latter. The article can at the same time be used under weather conditions where temperature shifts from low temperature to high temperature or, in case of using the article as a part of an aerial vehicle, where the temperature shifts from cold outer environment to warm outer environment due to descend of the aerial vehicle towards the earth surface. Such shift in temperature will result in a temperature difference between the outer environment and the interior of the article and where the interior is of lower temperature than outside, condense is due inside the article. At the same time as the article can be protected from erosion, the adhesion of the metal coating is guaranteed to be adhered to the composite skin over a long life time since no moisture would be trapped between the coating and the composite skin. Moisture trapped in the interface would otherwise affect the adherence properties negatively. The porosity of the coating permits the transportation of moisture from the interface to the outer atmosphere outside the article. The coating provides porosity and an open area of the composite promoting moisture transportation from the composite to the atmosphere at the same time as the aerodynamic surface of the leading edge is erosion protected.

Suitably, the thickness of the coating is between about 1 µm to 100 µm.

Alternatively, the thickness of the coating is between about 75 µm to 500 µm.

Suitably, the porosity of the coating is about 2 % to 40 %, preferably 4 % to 20 %, for permitting a moisture transmission from the composite skin to the outer atmosphere. Water vapor transmission is thereby permitted, wherein the moisture (water) can be transferred by diffusion through the coating. Thus, an article is provided with an erosion protection that provides aerodynamic efficiency (providing and maintaining a smooth outer surface) over a long time and which can be used under extreme weather conditions where cold outer environment momentary prevails and eroding hails hit the leading edge. Also, an article is provided that prevents moisture damage to the article structural parts since the moisture being permitted to be transferred through the erosion resistant coating. It is extremely important that all water trapped within the interior of the article can diffuse and also moisture within the composite skin per se. According to the invention of claims 1 and 9, the porosity of the coating is lower in areas meeting the airflow, than in areas where the article extension follows the airstream during said use.

This means that the coating covering the leading edge has a more dense porosity than the coating covering the airfoil's (wing's) upper and lower side. Suitably, the porosity of the coating is lowest within the area of the stagnation points. In such way is weight saved due to the use of optimal use of proper density (determined by porosity) of the coating, i.e. it is determined not to use dense coating at places of the wing, where the erosion is near non-existent. At the same time the adhesion of the coating to the plastic or resin (or composite) of the substrate will be durable since water is permitted to be transferred through the erosion-resistant coating of metallic material and water will not be trapped in the interface between coating and substrate.

Suitably, the coating excludingly is of a metallic material.

In such way is achieved an article aerodynamic surface that can be polished to an extreme smooth and hard surface. The leading edge easy can be manufactured with or without any recess in the outer surface of the composite skin. In case of no recess there is a possibility to apply the coating onto the leading edge wherein the coating's outermost edges are finished to the same level as the composite skin aerodynamic surface. In case of using recess in the leading edge for encompassing the coating, the recess depth should be of the same measure as the thickness of the coating.

Preferably, the thickness of the metallic coating is about 1-2 µm.

Suitably, the thickness of the metallic coating is about 1-10 µm or thicker.

Preferably, the metal is titanium or aluminium or nickel.

In such way is achieved that a cost-effective production of the article is possible at the same time as the article will be of low weight. Titanium or other metal is possible to polish to an extraordinarily smooth surface.

Suitably, the metal is copper.

In such way it will be possible to efficient use the article skin and coating of the aircraft (such as a wing) for lightning protection. This means that prior art lightning protective copper meshes bonded to the aerial structure outer surface are not necessary. The present embodiment of providing a metal (e.g. copper) coating of a wing is a cost-effective way to produce a lightning protection conductive layer which keeps the energy outside avionics, fuel systems etc. at the same time as moisture will not be trapped within the composite. A carbon fiber epoxy skin normally serves as an electrical insulator and the present coating will, not only provide the transmission/diffusion of moisture from the interface, but also provide an additional electrical conductivity to the outside of the skin. The coating is therefore durable in view of lightning.

Preferably, the coating is applied as a strip having a width covering an area of a leading edge extending between leading edge stagnation points of low angle of attack and leading edge stagnation points of high angle of attack.

In such way is provided that when the aircraft is flying with a high angle of attack (for example during final approach), the area corresponding with the stagnation point of low angle of attack will be positioned at the point where the airflow is sweeping over the leading edge on the wing suction side. As the erosion protective cover protects the composite from erosion in this area during low angle of attack, the aerodynamic surface will be kept smooth, which is aerodynamically efficient during said final approach. Furthermore, as also the stagnation point of high angle of attack is protected, the leading edge at pressure side of the wing (leading edge under side) will have a smooth aerodynamic surface (laminar airflow) when the aircraft is in level flight. All stagnation points between the high angle of attack and the low angle of attack are covered by the strip coating.

Suitably, the coating is applied as a strip having a width at least covering an area of the leading edge extending between the leading edge stagnation points of zero angle of attack and essentially a distance further chordwise of the leading edge stagnation points of high angle of attack.

In such way is achieved that the stagnation points of zero angle of attack during accelerating take-off action on runway or landing, will be protected from erosion, which means that this surface of the leading edge (upper side towards suction side of the wing) will be smooth (resulting in laminar air flow) during both level flight and final approach.

Preferably, the coating essentially extends over the entire article.

In such way is achieved an article having a skin that is resistant against accidental drop of tools by service personal. Preferably, the coating is applied within areas of the article, such as service hatches, control airfoil surfaces etc. In such way is achieved that the aerodynamic surface of a wing, or leading edge especially, can be protected from erosion. At the same time, the conductivity of the coating provided for incorporating the coating into a lightning protection system of an aircraft.

This is also solved by a method as claimed by claim 10.

Thereby is achieved a cost-effective production of erosion resistant coating providing a moisture transportation.

Preferably, the method comprises a step of providing a recess in the composite skin for accommodating the coating, the recess is provided by compressing a lay-up against a forming surface of a forming tool, which surface exhibits a film or other protruding section.

Suitably, the coating is applied so that the outermost portion of the coating, adjacent the outer surface of the coating (aerodynamic surface), exhibits more dense (packed) metal molecules (or grains) for reaching an erosion protective outer surface, but not so dense that moisture is hindered to evaporate or transmit through said outermost portion.

Suitably, at the same time (for saving weight) the inner portion of the coating may exhibit less dense (packed) metal molecules (or grains) for still reaching the moisture transmission property.

Preferably, the coating is provided over the leading edge.

Suitably, the parameters for achieving the metallic coating exhibiting the proper porosity are selected from sprayed material temperature, velocity of the material impacting the substrate surface, the angle of impact, and also such parameter as the quantity of gas contacts and reaction between the metallic material and said gases under the deposition process. The inventors of the present application have surprisingly noticed that high-velocity of the atomized metallic material will produce upon impact flattened or flake formed metal particles or grains of extremely small size, the flake formed particles will give a thin layer property saving weight and the process parameters are set so that the coating properties are altered towards a well-defined pre-determined porosity of the metal coating.

Alternatively, the step of providing the erosion resistant coating material exhibiting said predetermined porosity is performed simultaneously with the step of applying the material onto the composite skin.

In such way is achieved that a method of spraying the article at the same time as the porosity properties are determined depending upon which outer surface portion of the article being sprayed, leading edge, trailing edge, stagnation points, suction side of wing, pressure side of wing, rudder fastening areas for lightning protection, etc. The leading edge is preferably coated with Al, Ti, MMC etc. by thermal spray coating or flame spraying.

Preferably, a finishing step of finishing the composite substrate surface is made before the step of applying the coating material. The finishing is preferably made by a surface treatment energizing the latter for satisfactory adhesion between the coating and substrate. By this means it is possible to keep the substrate temperature cool and unchanged and thereby no expansions of the substrate occur during the application.

Alternatively, the step of applying the material is made by thermal spray coating, such as plasma spray deposition.

Preferably, electro less plating is used for the application. The metal is in this case preferably nickel which is set with the proper porosity.

Suitably, the substrate surface is cleaned before application.

Preferably, the surface is thereafter subject for roughening for ensuring satisfactory bonding between the coating and the substrate.

Suitable, an area of the article not to be coated is masked.

Alternatively, a flame provider device is provided that melts a coating metallic material stock or metallic powder and thereafter atomized by a high-velocity gas-stream. The achieved well-defined porosity coating is finished for reaching a smooth aerodynamic surface. This can be made by grinding or polishing or by other means.

Suitably, the step of applying the material is made by vapor deposition, such as sputtering or sputtering deposition.

In such way an extreme thin metal coating can be achieved having the proper porosity, at the same time as it provides conductivity for lightning protection. In such case, it could be proper to use chromium, nickel, copper etc. or combinations of steel and other alloys.

Alternatively, the sputter deposition is made by means of a plasma application (e.g. bombardment) of the substrate to ensure a smooth aerodynamic surface.

Alternatively, plasma-based plating is used by accelerating ions from the plasma by a negative bias onto the substrate.

Suitably, a controlled potential release of bombarded gas provides the porosity percentage of the coating to about 2-40 % porosity, preferably 10-30 % porosity.

Preferably, the step of applying the material is made by ultra short pulsed laser deposition. In such way is used a technique that will be used in future more often for more industrial applications, such also for aircraft industry.

Alternatively, the step of applying the material onto the composite skin incorporates cold spray procedure for metal deposition.

Suitably, the application of the erosion resistant coating material is made by means of a portable applicator.

Thereby the aircraft already in service can be served in a cost-effective way and do not have to be demounted and transported to manufacture sites. In such way is achieved that in case the coating serves as a lightning protection system an eventual damage can be repaired by an adhesive exhibiting electrical conductive properties (by means of carbon nano tubes for example or other conductive nano filament structure added to e.g. epoxy system.

Alternatively, the applicator uses a portable vacuum chamber which is connected to the airframe. In such way is achieved a controllable environment surrounding the damage area.

Suitably, the coating is used separately or in combination on a surface of an aircraft serving as part of a lightning protection system, anti-icing/de-icing system or plasma generating system.

By using a metal having the same or similar thermal expansion properties as the plastic of the article, the aerodynamic surface can exhibit the proper smoothness over long time.

Suitably, a controlled potential release of bombarded gas of a plasma spray coating provides the porosity percentage of the coating to about 2-40 % porosity, preferably 10-30 % porosity.

Suitably, the parameters for achieving the metallic coating exhibiting the proper porosity are selected from sprayed material temperature, velocity of the material impacting the substrate surface, the angle of impact, and also such parameter as the quantity of gas contacts and reaction between the metallic material and said gases under the deposition process. According to the invention of claims 1 and 9, the porosity of the coating is lower in areas meeting the airflow, than in areas where the article extension follows the airstream during said use. This means that the coating covering the leading edge has a more dense porosity than the coating covering the airfoil of the wing's upper and lower side.

Suitably, the porosity of the coating is lowest within the area of the stagnation points. In such way is weight saved due to the use of optimal use of proper density (determined by porosity) of the coating, at the same time as the coating can be used for lightning protection of the article, de-icing/anti-icing and erosion protection at the same time. Preferably, cavities of the coating (exhibiting the porosity) are filled with cured resin for achieving a smooth aerodynamic surface. Eventual moisture will diffuse, not only through the composite, but also through the cured resin of the cavities.

By experiments performed by the applicant the porosity percentage of the coating is suitably set to about 2-40 % porosity, preferably 10-30 % porosity. This will provide sufficient open areas of the composite facing the atmosphere for moisture transmission to the atmosphere, but still sufficient dense erosion protection coating for achieving natural laminar flow for long-life use of the aircraft.

### BRIEF DESCRIPTION OF THE DRAWINGS

The present invention will now be described by way of examples with references to the accompanying schematic drawings, of which:
Fig. 1a illustrates a leading edge of a wing comprising an erosion resistant coating;
Fig. 1b shows a transition area between the coating and the outer surface;
Fig. 1c shows another embodiment, where the composite skin comprises a recess;
Figs. 1d-1e illustrate method embodiments to provide a recess for the coating;
Figs. 2a-2b illustrate a coating according to further embodiment;
Fig 3a illustrates a closer view of a porous coating of a composite skin laminate;
Fig. 3b illustrates a leading edge of a vertical stabilizer;
Fig. 4 shows a trailing edge of a rudder;
Fig. 5 illustrates a commercial aircraft;
Figs. 6a-6b illustrate a method of applying an erosion resistant coating;
Fig. 7 shows a sputtering deposition process;
Fig . 8 illustrates a mobile coating application apparatus used at airports;
Fig. 9 illustrates the principle of a coating material deposit area of a leading edge;
Fig. 10 shows a profile skin and coating of an aerial VOR-antenna;
Fig .11 illustrates a further embodiment of the coating applied to a wing; and
Fig. 12 shows an apparatus arranged for application of MMC-material.

### DETAILED DESCRIPTION

Hereinafter, embodiments of the present invention will be described in detail with reference to the accompanying drawings, wherein for the sake of clarity and understanding of the invention some details of no importance are deleted from the drawings.

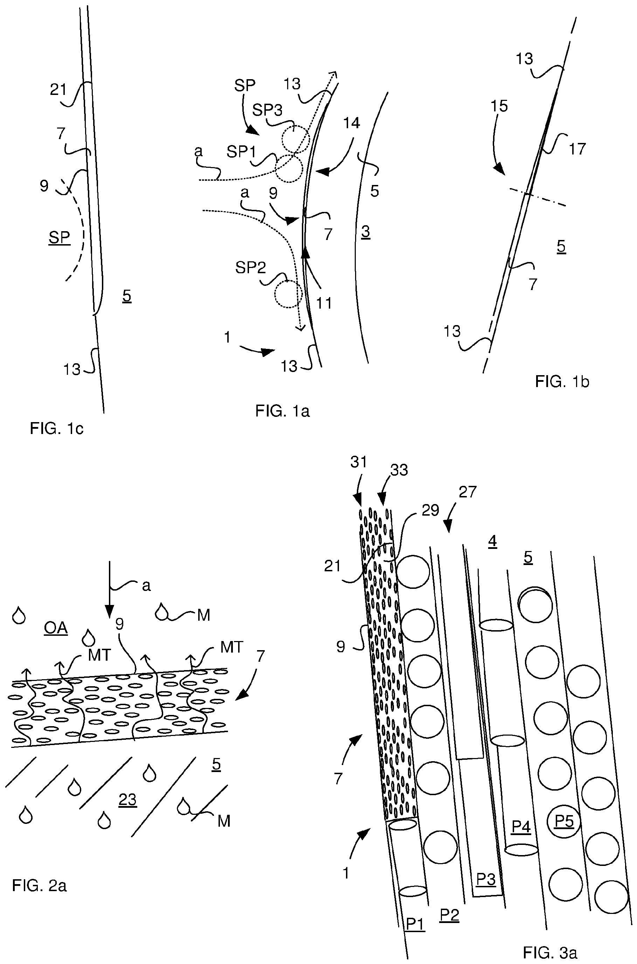

Fig. 1a schematically illustrates a leading edge 1 of a wing 3. The leading edge 1 comprises a composite skin 5. During use of the leading edge 1, the airflow a divides into an upper (suction) and lower (pressure) airflow streaming around the wing 3. The point where the airflow a impacts the leading edge 1 is called the stagnation point SP. Of course, there will be an indefinite number of stagnation points SP along the leading edge 1 following an imaginary line intersecting with the line of stagnation points SP.

The airflow will swirl at stagnation points and prior art aerodynamic surface of the leading edge at this point is critical in view of erosion during flight.

The Fig. 1a shows three different stagnation points SP1, SP2, SP3 (or sets/lines of stagnation points). The first stagnation point P1 represents a level flight stagnation point, where the aircraft wing 3 performs normal angle of attack. The second stagnation point SP2 represents a slow speed flight stagnation point, where the aircraft wing 3 performs high angle of attack. The third stagnation point SP3 represents an angle of attack where the leading edge 1 meets the airflow a symmetrically or with zero angle of attack. The composite skin 5 (serving as a substrate) of the leading edge 1 comprises an erosion resistant coating 7 of about 10 µm comprising a metallic material, the metallic material being in this embodiment of aluminium and is excludingly of aluminium comprising micro cavities (not shown) providing porosity and open area of the composite promoting moisture transportation from the composite to the atmosphere at the same time as the aerodynamic surface of the leading edge is erosion protected. An upper side of the coating 7 exhibits an aerodynamic surface of the leading edge 1. The coating 7 has been cold sprayed onto the leading edge 1 within an area defined by the wing's 3 wingtip and wing root (not shown) and upper and lower limits determined by the second stagnation point SP2 and the third stagnation point SP3. The coating 7 is of such high porosity (due to said cavities) that eventual (during use of the aircraft) trapped moisture within the wing 3 interior or composite wing skin 5 is able to diffuse from the composite skin 5 and through the coating 7 to atmosphere. The atmosphere is in contact with the coating 7 outer surface 9 representing a portion of the aerodynamic surface of the wing. Furthermore, the coating 7 has such low porosity that erosion protection still being achieved during said use. In such way is achieved that eventual moisture embedded within the composite skin 5 can diffuse from the composite skin 5 without being trapped in an interface 11 defined between the coating 7 and the outer surface 9 of the composite skin 5. The aircraft can thereby be used under extreme wheatear conditions at low temperatures and being subjected to ice crystals, hail and rain. The aircraft is protected from erosion and no cavitation erosion is affecting the leading edge 1. At the same time, low weight of aircraft is achieved due to low weight of composite skin 5 and due to said moisture transportation. The coating 7 is applied as a strip 14 having a width at least covering an area of the leading edge 1 extending between the leading edge stagnation point SP3 of zero angle of attack and in chordwise direction the leading edge stagnation points SP2 of high angle of attack.

Fig. 1b schematically shows a transition area 15 between the coating 7 and the outer surface 13 of the composite skin 5. The transition area 15 comprises an end portion 17 of the coating 7 being polished to a smooth and level surface, which end portion 17 becomes thinner and thinner in a direction towards the exposed outer surface 13 of the composite skin 5. In such way no steps appear in the aerodynamic surface, which steps otherwise would produce turbulence. Fig. 1c schematically shows another embodiment, where the composite skin 5 outer surface 13 (at the area defined by above mentioned specific determined stagnation points SP2-SP3) is provided with an extremely shallow recess 21 of about 15 µm depth (i.e. corresponding with the thickness of the coating 7), which recess 21 being elongated along the leading edge 1 outermost portion. After cleaning of the recess 21, the outer surface of the recess 21 is roughened for ensuring satisfactory bonding between the coating and the outer surface. The areas surrounding the recess 21, which areas will not exhibit any coating, are painted with a release film, which serves as a masking. The step of applying the coating material is made by a plasma spray deposition. The coating 7 is finished after curing (being rigid) of said coating material.

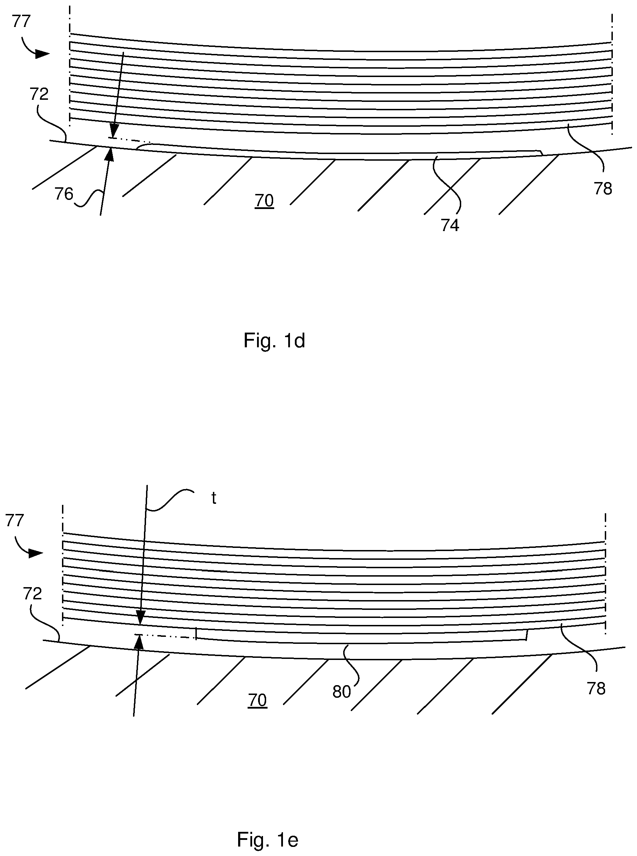

Fig. 1d schematically illustrates a method for providing a recess for a thin metallic foil (thickness of 20 µm) recess (not shown) for application of a foil (not shown) onto a laminate (lay-up 77 of pre-pregs 78 being cured) of a leading edge. A forming tool 70 is provided with a forming surface 72. The forming surface 72 is arranged with a protruding section 74 corresponding with the position of the foil onto the leading edge, which foil is to be applied onto the laminate. The forming surface 72 exhibits a protrusion thickness 76 (20 µm) corresponding with the thickness of the foil. The lay-up 77 of pre-pregs 78 being applied onto the forming surface 72. The lay-up 77 is compressed and cured in the forming tool 70. The protruding section 74 will form the recess due to the compression. The formed surface of the finished composite laminate thus will exhibit a recess of 20 µm depth. This promotes a cost-effective production of leading edges, as all articles formed and cured by the forming tool 70 will have the appropriate recess corresponding with the thickness of the foil. Thereafter, the foil is adhered to the recess of the laminate by means of an adhesive.

Fig. 1e schematically illustrates a method for providing a coating (not shown) (cold sprayed onto the laminate of the leading edge) in a recess (not shown) of the laminate. In this embodiment the lay-up 77 is provided with a film 80 having a thickness t corresponding with the coating (10 µm). The film 80 will make an impression (corresponding with the recess) in the laminate 71 corresponding with the thickness of the film 80 when the lay-up 77 is compressed. The film 80 is provided with a release agent (not shown) so that it efficiently can be released from the laminate recess after curing. Thereafter the coating is sprayed in the recess. The forming tool 70 will efficient be modified to other coating thicknesses and coating extensions of the leading edge, as only the film 80 has to be exchanged in the forming tool so that the film corresponds with the desired thickness and extension.

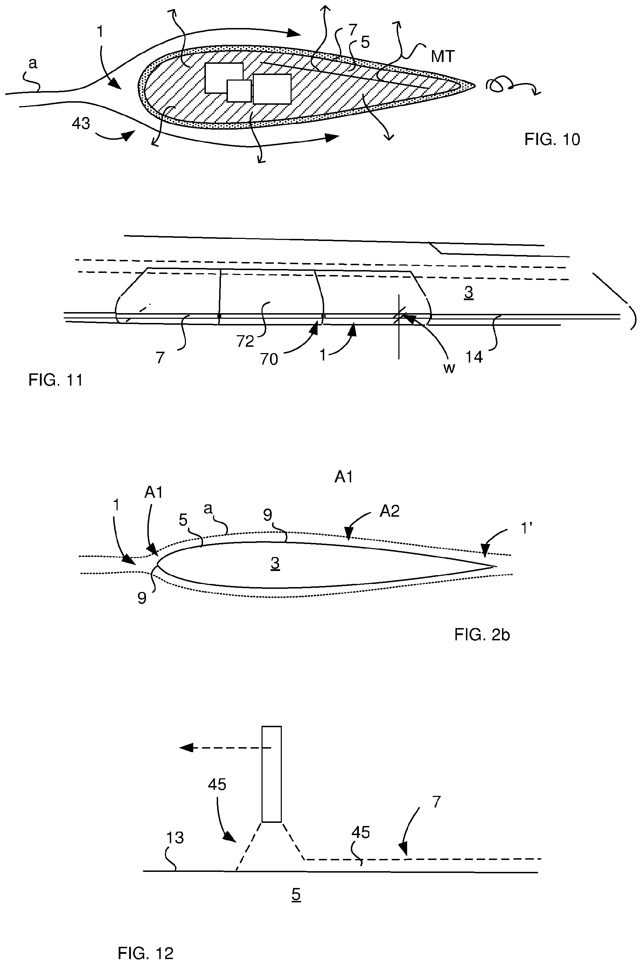

Fig. 2a schematically illustrates a coating 7 according to another embodiment. The porosity of the coating is about 2 % to 40 %, preferably 4 % to 20 %, for permitting a moisture transmission MT from the interior of the aerial article 23 to the outer atmosphere OA via an open area of the composite where the coating (e.g. of the leading edge) is positioned. The open area of the composite thus faces the atmosphere (i. e. the composite area below the coating, which area due to the porosity of the coating is open to and exposed to the atmosphere) and is achieved by the said porosity of the coating. Moisture transmission is thereby permitted, wherein the moisture can be transferred by diffusion through the coating 7 at the same time as the porosity is selected such that erosion protection is achieved. In this embodiment (see also Fig. 2b), the porosity being lower in the area A1 meeting the airflow a than in the area A2, where airfoil surface extension of the article follows the airstream AF during said use. Furthermore, the porosity is selected so that the coating 7 is more dense in sections facing the airstream a, than in other sections. The porosity of the coating is however continuously seen in a direction transverse the coating thickness. The entire airfoil article is fully covered by the coating 7, the upper and lower surfaces of the wing 3 will have a coating 7 of high porosity, and leading edges 1 and trailing edges 1' will have a coating 7 of low porosity. The coating 7 exhibits a thickness of about 12 µm. In this embodiment, the metal of the coating 7 is of copper material and the coating 7 efficiently being used in a lightning protection system of the aircraft. The present coating 7 provides a cost-effective way to produce a lightning protection conductive coating 7, which keeps the energy out of avionics, fuel systems etc., which coating 7 effectively conducts the energy overboard.

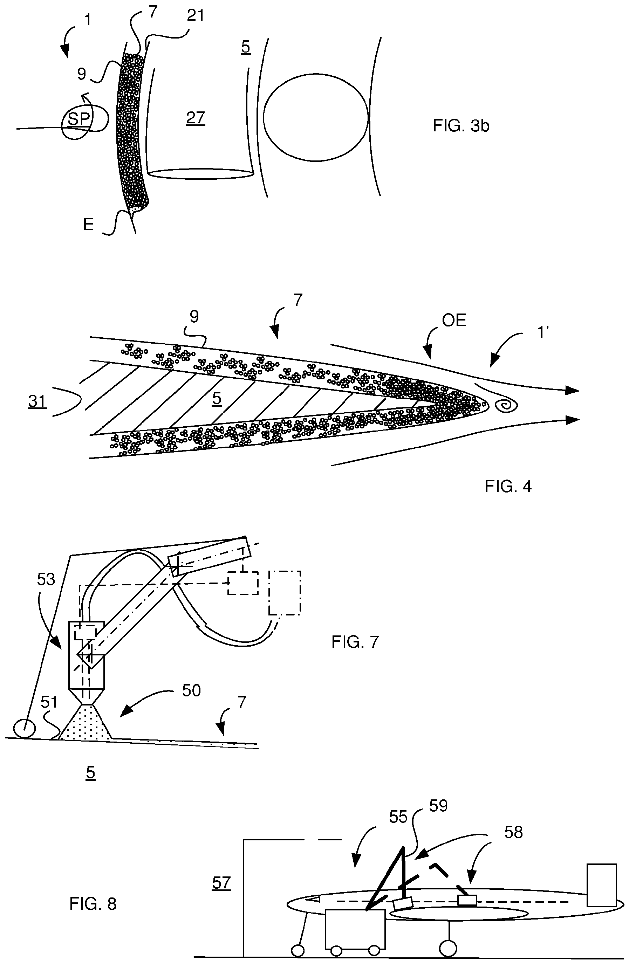

Fig. 3a schematically illustrates a closer view of the composite skin 5 laminate of an airfoil 4 serving as an aerodynamic surface when the airfoil 4 is used. The laminate comprises a plurality of plies P1, P2, P3 etc. stacked onto each other. Each ply P1, P2, P3 etc. comprises a carbon fiber structure 27 differently oriented than fibers of other plies. A recess 21 is made in the outermost ply P1 and a coating 5 is applied to the recess 21. The recess 21 is positioned at the airfoil 4 in a position corresponding with the position of the stagnation point SP of the airfoil 4 leading edge 1 during level flight and is made along the leading edge. In this example, the coating 7 is relatively thick, about 1 mm, and the recess 21 is provided by just leaving out a portion of the outermost ply P1 in the actual area. The surrounding areas of the composite skin surrounding the recess 21 are masked and the coating 7 is applied by means of painting. The coating 7 comprises low weight titanium. The porosity of the coating 7 is about 20-30 %. The inner portion 33 of the coating 7 comprises about 30% porosity, which being illustrated by means of cavities 29 which have larger total volume than the outer portion 31 of the coating 7. The cavities 29 are filled with cured resin for achieving a smooth aerodynamic surface. Fig. 3b schematically illustrates a leading edge 1 of a vertical stabilizer. The leading edge 1 composite skin 5 thus comprising the shallow recess 21 having a position corresponding with the position of the stagnation points SP. The depth of the recess 21 corresponds with the thickness of the coating 7 and is about 8 µm. The material of the coating 7 is nickel and the application of the coating 7 has been made by a cold spray procedure (not shown). The nickel of the coating 7 being applied with such high porosity (15-20%) that moisture transportation is permitted from the composite skin 5 to outer surface 9 of the coating 7, and of such low (5-10%) porosity that erosion protection still is achieved. Epoxy resin E is also applied in occurring grooves between composite skin 5 material and coating material 7. After curing the epoxy E is polished for achieving a smooth aerodynamic surface. The porosity decreases (seen in a direction from the composite skin 5 and transverse the coating 7 extension) towards the outer surface 9 (aerodynamic surface) of the coating 7. The porosity will thus be higher near the composite skin 5 and lower near the aerodynamic surface. Said more dense (outer) portion of the coating 7 provides extremely high resistance against rain erosion, and said more porous portion (inner) of the coating 7 promotes moisture transportation through the coating 7.

Fig. 4 schematically illustrates a trailing edge 1' of a rudder 31 mounted to the fin in Fig. 3b. The porosity of the coating 7 is lowest within the area of outermost edge OE of the trailing edge 1' and parallel with an imaginary line defined by an indefinite number of stagnation points (SP') (only one being shown). The adhesion of the coating 7 to the composite of the composite skin 5 is durable, since eventual trapped water within the composite is permitted to transfer through the coating 7 to the outer surface 9. The coating 7 essentially extends over the entire rudder 31. The composite skin 5 of the rudder 31 is thereby resistant against accidental impacts by service tools (not shown) or the like. Areas of the composite skin 5, such as service hatches and attachment joints (not shown) as well are protected from erosion. In Fig. 4 is shown that the porosity is lower towards the trailing edge 1' and higher porosity is provided for the coating applied onto other outer surfaces of the rudder 31. In such way the rudder can be made with even lower weight.

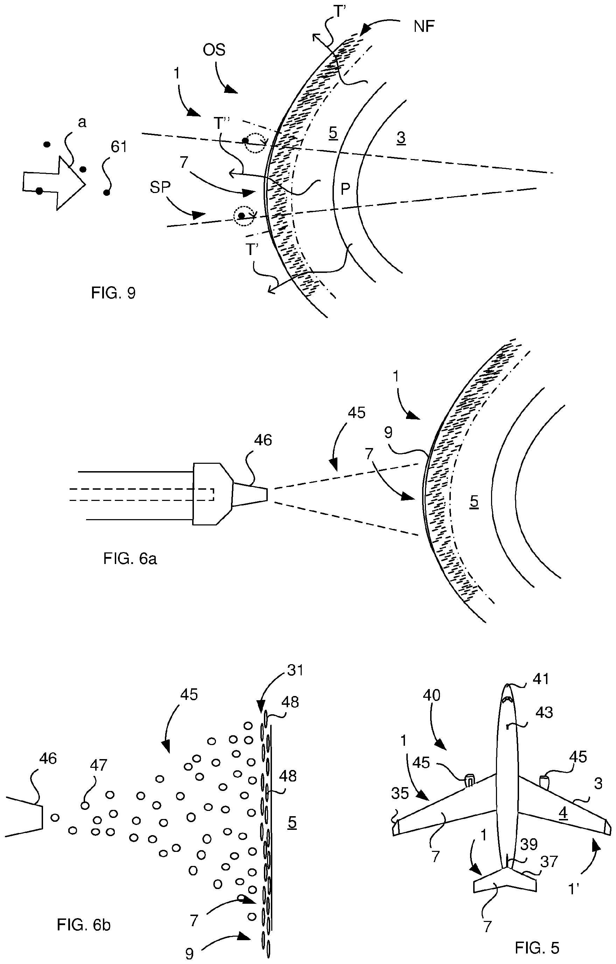

Fig. 5 schematically illustrates a commercial aircraft 40 covered by coatings 7 of the type disclosed in Fig. 1a. The aircraft 40 comprises a plurality of leading edges 1 of winglets 35, wings 3, a stabilizer 37, fin 39, nose cone 41, antennas 43, engine fairings 45 etc. Each leading edge 1 faces the airstream when the aircraft 40 moves through the air. The aircraft 40 also comprises trailing edges 1' of the type shown in Fig. 4.

Fig . 6a schematically illustrates a method of applying an erosion resistant coating 7 to a composite skin 5 of a wing. The coating 7 comprises a metallic material. The method includes the use of a portable spray nozzle 46 adapted to spray the material along the curvature of the airfoil and at a predetermined distance. The method for applying said material onto the composite skin is made by cold spray procedure. It is achieved by providing the erosion resistant coating material 45 in such way that it, when it has hardened on the composite skin 5, exhibits a predetermined porosity such that a moisture transportation during said use is possible from the composite skin 5 to the outer surface 9 of the coating 7, but still providing an erosion protection of the latter. The method according to this embodiment also comprises the step of applying the erosion resistant coating material 45 onto the composite skin 5 over a selected area of the article, in this case over the leading edge 1. Finally, the outer surface 9 of the coating 7 is polished (not shown), so that a smooth aerodynamic surface being achieved. Thereby is achieved a cost-effective production of erosion resistant coating 7 permitting a moisture transportation there through. In Fig. 6b is schematically illustrated closer in detail the application in Fig. 6a. The coating 7 is applied onto the composite skin 5 so that the outermost portion 31 of the coating, adjacent the outer surface 9 of the coating 7 (aerodynamic surface), exhibits more dense (packed) structure of metal molecules (or grains) for reaching an erosion protective outer surface 9, but not so dense that moisture is hindered to evaporate or diffuse through said outermost portion 31. Metallic drops 47 (atomized metallic material) sprayed from the spray nozzle 46 are caused a high-velocity and will upon impact onto the composite skin 5 be flattened out or flake formed. The metal particles or metal grains will be of extremely small size and will constitute flake formed particles 48 as schematically illustrated in Fig. 6b. Such procedure will give a thin layer property saving weight at the same time as a robust coating 7 is achieved. The spray parameters are set so that process parameters alter the coating 7 properties aiming towards a well-defined porosity of the metal coating 7. In this example, the parameters for achieving such well-defined porosity are selected from the parameters temperature, velocity, angle of impact, gas quantity of the erosion resistant coating material 45.

In fig. 7 schematically is illustrated a vapor deposition process or so called sputtering deposition of copper material 50. In such way an extreme thin metal coating 7 can be achieved having the proper porosity, at the same time as it provides conductivity for lightning protection. The sputter deposition is made by means of a plasma bombardment onto the composite skin substrate 51 to ensure a smooth aerodynamic surface. The controlled potential release of bombarded gas provides a porosity percentage of the coating 7, suitably about 2 % to 40 %, preferably 4 % to 20 %. The method is performed by skilled personnel in a work-shop (not shown) by use of an automatic pre-programmed sputtering apparatus 53. Sputtered ions ballistically fly in straight lines and impact energetically on the composite skin 5. This is optionally made in a vacuum chamber. At higher gas pressures the ions will collide with gas atoms that act as moderator for diffusion and reach the composite skin 5 for condensation. The sputtering gas is in this embodiment an inert gas.

Fig . 8 schematically illustrates a mobile coating application apparatus 55 to be used at airports 57. The apparatus 55 comprises an ultra short pulsed laser deposition (USPLD) device 58. In such way is used a technique that is easy and cost-effective to handle. The apparatus 55 is programmed to apply the coating material automatically onto the aircraft 40 wing 3 and a spray nozzle being controlled by a robot arm 59.

Fig. 9 schematically illustrates the principle of defining a deposit area of a leading edge 1. The coating 7 has been applied by means of a flame spraying device (not shown). The coating material is MMC (metal matrix composite). The coating 7 is bond to the outermost surface of a composite skin 5 of a wing 3. The laminate comprises several fiber reinforced cured resin plies P. The outermost surface of the laminate comprises a nano filament structure NF for reaching an extreme hardness of the aerodynamic surface. During use, the wing 3 meets the airflow a. Particles, such as dirt 61 in rain drops of the air, hit the wing 3, especially in the area of the leading edge 1. The coating 7 protects the airfoil from rain erosion in the outermost section OS of the leading edge 1, where the airflow a swirls. In this example, the coating 7 is applied thicker in the critical area of the leading edge 1, i.e. where the stagnation points SP are positioned at level flight. Transmission of moisture is permitted from the composite skin both in coated areas 7 (T") and in areas without coating (T').

Fig. 10 schematically illustrates the profile of a civil aircraft antenna 43 in cross section. A copper coating 7 is applied to the entire antenna 43 outer side covering the entire composite skin 5. The airflow a streams over the composite skin 5 comprising the coating 7, which composite skin 5 being protected from erosion by the coating 7. By the proper selected porosity of the coating 7, eventual trapped moisture within the antenna 43 fairing interior and/or composite skin 5 will be permitted to transfer or diffuse MT through the composite skin 5 and evaporate. At the same time, the conductivity of the copper coating 7 is used and the coating 7 is coupled to a lightning protection system (not shown) of the aircraft. Weight is saved and no additional lightning protection conductive layer has to be arranged onto the composite skin 5.

Fig .11 schematically illustrates a coating 7 applied to a composite skin 5 of a wing 3 as a strip 14 having a width w, covering and being addressed to, an area of the leading edge 1 extending between the leading edge stagnation points of low angle of attack and the leading edge stagnation points of high angle of attack. The erosion protective coating 7 protects the leading edge composite skin 5 from erosion in said area during normal flight (low angle of attack). The aerodynamic surface in this area will over long time be smooth. During final approach, the angle of attack is increased and the actual area (strip) will be positioned under the suction side of the wing wherein laminar air stream sweeps over the leading edge without any disturbance due to erosion. Joints 70 between airfoil sections 72 are filled with epoxy and finished to a smooth aerodynamic surface.

Fig. 12 schematically illustrates an apparatus arranged for application of a MMC (metal matrix composite) coating material onto an airfoil article 4 of an aircraft. The step of providing the erosion resistant coating material 45 exhibiting a predetermined porosity is performed simultaneously with the step of applying the material 45 onto the composite skin 5. In such way is achieved that a method of spraying the article 4 at the same time as the porosity properties are determined depending upon the type of outer surface 9 of the article being sprayed. This means that the coating 7 will cover the leading edge and that is applied in a cost-effective way and the coating 7 involves a more dense porosity than the coating covering the composite skin of the article 4 upper and lower surface. The porous coating material is applied to the surface 13 of the composite skin 5. A diffusion bond will occur between flattened spherical particles of the coating material and the outer surface 13 of the composite skin 5.

The present invention is of course not restricted to the embodiments described above, but many possibilities to modifications, or combinations of the described embodiments, thereof should be apparent to a person with ordinary skill in the art without departing from the scope of the invention as defined in the appended claims. The recess of the composite skin of the leading edge can be achieved by machining, polishing, leaving out pre-preg tape in outermost ply, providing the forming and curing tool with a protrusion corresponding with the desired recess. Alternatively, if the coating thickness is about 1 µm or less, no recess is necessary. Alternatively, a foil or film, which exhibits the corresponding thickness as the coating, can be applied side by side/adjacent the coating and joining the latter for reaching a continuous curvature of the aerodynamic surface. The porosity of the coating is about 2 % to 40 %, preferably 4 % to 20 %, for permitting a moisture transmission from the interior of the aerial article to the outer atmosphere via an open area of the composite where the coating (e.g. of the leading edge) is positioned. The open area of the composite thus faces the atmosphere (i. e. the composite area below the coating, which area due to the porosity of the coating is open to and exposed to the atmosphere) and is achieved by the said porosity of the coating. Moisture transmission is thereby permitted, wherein the moisture can be transferred by diffusion through the coating at the same time as the porosity is selected such that erosion protection is achieved. Composite is defined as cured resin (plastic) comprising reinforcement fibers.

## Claims

1. An aerial article comprising a composite skin (5), a leading edge (1) facing the airflow (a) during the use of the aerial article (3, 4), an erosion resistant coating (7) comprising a metallic material, and an aerodynamic surface (9), **characterized by that** the coating (7) partly or entirely covers the composite skin (5) of the aerial article (3, 4), wherein the coating (7) is of such high porosity providing an open area, diffusion passage way, so that moisture transportation (MT) is permitted from the composite skin (5) to the aerodynamic surface (9) of the coating (7), and of such low porosity that erosion protection of the composite skin (5) still is achieved during said use, wherein the porosity of the coating (7) is lower in areas of the article (3, 4) meeting the airflow (a), than in areas where the aerodynamic surface (9) of the article (3, 4) has its extension following the airstream (a) during said use.

2. The article according to claim 1, **wherein** the coating (7) is applied onto the composite skin (5) over an area corresponding with the stagnation point (P) of the leading edge (1).

3. The article according to claim 1 or 2, **wherein** the porosity of the coating (7) is 2 % to 40 %, preferably 4 % to 20 %, for permitting the moisture transmission (MT) from the composite skin (5) to the outer atmosphere.

4. The article according to any of the preceding claims, **wherein** the coating (7) excludingly is of a metallic material.

5. The article according to any of the preceding claims, **wherein** the metal is titanium or aluminium or copper.

6. The article according to any of the preceding claims, **wherein** the coating is applied as a strip (14) having a width covering an area of an leading edge (1) extending between leading edge stagnation points (SP1) of low angle of attack and leading edge stagnation points (SP2) of high angle of attack.

7. The article according to any of the preceding claims, **wherein** the coating (7) is applied as a strip having a width (w) at least covering an area of the leading edge extending between the leading edge stagnation points (P3) of zero angle of attack and essentially a distance further chordwise of the leading edge stagnation points (SP2) of high angle of attack.

8. The article according to any of the preceding claims, **wherein** the coating (7) essentially extends over the entire article (3).

9. A method of applying an erosion resistant coating (7) comprising a metallic material to a composite skin (5) of an aerial article (3), the composite of which during use of the article (3) may contain moisture, the aerial article (3) further comprises a leading edge (1) facing the airflow (a) during the use of the aerial article (3, 4) and comprising an aerodynamic surface (9), the method **comprises the steps of:**
- providing the erosion resistant coating (7) material exhibiting a predetermined porosity such that a moisture transportation (MT) during said use is possible from the composite skin (5) to the aerodynamic surface (9) of the coating (7), applying the erosion resistant coating material (45) onto the composite skin (5) over a selected area of the article (3);
wherein the porosity of the coating (7) is lower in areas of the article (3, 4) meeting the airflow (a), than in areas where the aerodynamic surface (9) of the article (3, 4) has its extension following the airstream (a) during said use;
- polishing the outer surface (9) of the coating (7) so that a smooth aerodynamic surface is achieved.

10. The method according to claim 9, **wherein** the step of providing the erosion resistant coating material (45) exhibiting said predetermined porosity is performed simultaneously with the step of applying the material (45) onto the composite skin (5).

11. The method according to claim 9 or 10, **wherein** the step of applying the material (45) is made by thermal spray coating, such as plasma spray deposition.

12. The method according to claim 9 or 10, **wherein** the step of applying the material (45) is made by vapor deposition, such as sputtering deposition.

13. The method according to any of the preceding claims, **wherein** the method comprises a step of providing a recess (21) in the composite skin (5) for accommodating the coating (7), the recess is provided by compressing a lay-up (77) against a forming surface (72) of a forming tool (70), which surface (72) exhibits a film (80) or other protruding section (74).

14. The method according to any of the preceding claims, **wherein** a film is applied onto the lay-up (77) for forming the recess (21).

15. Use of an aerial article according to any of claims 1-8 for serving as part of a lightning protection system, anti-icing/de-icing system or plasma generating system.

## Patentansprüche

1. Luftartikel umfassend eine Verbundhaut (5), eine Vorderkante (1), die dem Luftstrom (a) während der Verwendung des Luftartikels (3, 4) zugewandt ist, eine erosionsbeständige Beschichtung (7), die ein metallisches Material umfasst, und eine aerodynamische Oberfläche (9), **dadurch gekennzeichnet, dass** die Beschichtung (7) die Verbundhaut (5) des Luftartikels (3, 4) ganz oder teilweise überdeckt, wobei die Beschichtung (7) einer solchen hohen Porösität ist, dass ein offener Bereich, ein Diffusionsdurchgang, bereitgestellt wird, so dass ein Feuchtigkeitstransport (MT) aus der Verbundhaut (5) zur aerodynamischen Oberfläche (9) der Beschichtung (7) zugelassen wird, und einer solchen niedrigen Porösität ist, dass ein Erosionsschutz der Verbundhaut (5) während der Verwendung immer noch erreicht wird, wobei die Porosität der Beschichtung (7) in Bereichen des Artikels (3, 4), auf die der Luftstrom (a) trifft, niedriger ist als in Bereichen, wo während der Verwendung sich die aerodynamische Oberfläche (9) des Artikels (3, 4) dem Luftstrom (a) folgend erstreckt.

2. Artikel nach Anspruch 1, **wobei** die Beschichtung (7) auf die Verbundhaut (5) über einen Bereich, der dem Staupunkt (P) der Vorderkante (1) entspricht, aufgetragen ist.

3. Artikel nach Anspruch 1 oder 2, **wobei** die Porosität der Beschichtung (7) 2 % bis 40 %, vorzugsweise 4 % bis 20 % beträgt, um den Feuchtigkeitstransport (MT) aus der Verbundhaut (5) in die äußere Atmosphäre zu lassen.

4. Artikel nach einem der vorgehenden Ansprüche, **wobei** die Beschichtung (7) lediglich aus einem metallischen Material hergestellt ist.

5. Artikel nach einem der vorgehenden Ansprüche, **wobei** das Metall Titan oder Aluminium oder Kupfer ist.

6. Artikel nach einem der vorgehenden Ansprüche, **wobei** die Beschichtung als ein Streifen (14) aufgetragen ist, der eine Breite aufweist, die einen Bereich einer Vorderkante (1), der sich zwischen Vorderkante-Staupunkten (SP1) mit einem niedrigen Angriffswinkel und Vorderkante-Staupunkten (SP2) mit einem hohen Angriffswinkel erstreckt, überdeckt.

7. Artikel nach einem der vorgehenden Ansprüche, **wobei** die Beschichtung (7) als ein Streifen aufgetragen ist, der eine Breite (w) aufweist, die zumindest einen Bereich der Vorderkante, der sich zwischen den Vorderkante-Staupunkten (SP3) mit einem Angriffswinkel von Null und im Wesentlichen um einen Abstand weiter in Richtung des Cords der Vorderkante-Staupunkte (SP2) mit einem hohen Angriffswinkel erstreckt, überdeckt.

8. Artikel nach einem der vorgehenden Ansprüche, **wobei** die Beschichtung (7) sich im Wesentlichen über den gesamten Artikel (3) erstreckt.

9. Verfahren zum Auftragen einer erosionsbeständigen Beschichtung (7) umfassend ein metallisches Material auf eine Verbundhaut (5) eines Luftartikels (3), dessen Verbundstoff während der Verwendung des Artikels (3) Feuchtigkeit enthalten kann, wobei der Luftartikel (3) ferner eine Vorderkante (1) umfasst, die dem Luftstrom (a) während der Verwendung des Luftartikels (3, 4) zugewandt ist und eine aerodynamische Oberfläche (9) umfasst, wobei das Verfahren **die folgenden Schritte umfasst:**
- Bereitstellen des erosionsbeständigen Beschichtungsmaterials (7), die eine solche vorgegebene Porosität aufweist, dass während der Verwendung ein Feuchtigkeitstransport (MT) aus der Verbundhaut (5) zur aerodynamischen Oberfläche (9) der Beschichtung (7) ermöglicht wird, Auftragen des erosionsbeständigen Beschichtungsmaterials (45) auf die Verbundhaut (5) über einen ausgewählten Bereich des Artikels (3);
**wobei** die Porosität der Beschichtung (7) in Bereichen des Artikels (3, 4), auf die der Luftstrom (a) trifft, niedriger ist als in Bereichen, wo während der Verwendung sich die aerodynamische Oberfläche (9) des Artikels (3, 4) dem Luftstrom (a) folgend erstreckt;
- Polieren der Außenfläche (9) der Beschichtung (7) derart, dass eine glatte aerodynamische Oberfläche erhalten wird.

10. Verfahren nach Anspruch 9, **wobei** der Schritt des Bereitstellens des erosionsbeständigen Beschichtungsmaterials (45), das die vorgegebene Porosität aufweist, gleichzeitig mit dem Schritt des Auftragens des Materials (45) auf die Verbundhaut (5) ausgeführt wird.

11. Verfahren nach Anspruch 9 oder 10, **wobei** der Schritt des Auftragens des Materials (45) durch Thermospritzbeschichtung, wie beispielsweise Plasmaspritzbeschichtung, ausgeführt wird.

12. Verfahren nach Anspruch 9 oder 10, **wobei** der Schritt des Auftragens des Materials (45) durch Aufdampfung, wie beispielsweise Sputterdeposition, ausgeführt wird.

13. Verfahren nach einem der vorgehenden Ansprüche, **wobei** das Verfahren einen Schritt des Bereitstellens einer Aussparung (21) in der Verbundhaut (5) zur Aufnahme der Beschichtung (7) umfasst, wobei die Aussparung durch Zusammendrücken eines Überzugs (77) gegen eine Formfläche (72) eines Formwerkzeugs (70) bereitgestellt wird, welche Fläche (72) eine Folie (80) oder einen anderen hervorstehenden Abschnitt (74) aufweist.

14. Verfahren nach einem der vorgehenden Ansprüche, **wobei** eine Folie auf den Überzug (77) zur Bildung der Aussparung (21) aufgetragen wird.

15. Verwendung eines Luftartikels nach einem der Ansprüche 1-8 zur Anwendung als Teil eines Blitzschutzsystems, eines Anti-Vereisungssystems oder eines Plasmaerzeugungssystems.

## Revendications

1. Article aérien comprenant une peau composite (5), un bord d'attaque (1) faisant face au flux d'air (a) pendant l'utilisation de l'article aérien (3, 4), un revêtement résistant à l'érosion (7) comprenant un matériau métallique, et une surface aérodynamique (9), **caractérisé en ce que** le revêtement (7) couvre en partie ou en totalité la peau composite (5) de l'article aérien (3, 4), le revêtement (7) présentant une porosité élevée fournissant un trajet de passage de diffusion à surface ouverte, si bien que le transport d'humidité (MT) est autorisé de la peau composite (5) à la surface aérodynamique (9) du revêtement (7), et d'une porosité si faible que la protection contre l'érosion de la peau composite (5) est encore obtenue pendant ladite utilisation, dans lequel la porosité du revêtement (7) est plus faible dans des zones de l'article (3, 4) rencontrant le flux d'air (a), que dans les zones où la surface aérodynamique (9) l'article (3, 4) a son extension suivant le courant d'air (a) lors de ladite utilisation.

2. Article selon la revendication 1, **dans** lequel le revêtement (7) est appliquée sur la peau composite (5) sur une zone correspondant au point de stagnation (P) du bord d'attaque (1).

3. Article selon la revendication 1 ou 2, **dans lequel** la porosité du revêtement (7) est de 2 % à 40 %, de préférence de 4 % à 20 %, pour permettre la transmission d'humidité (MT) de la peau composite (5) vers l'atmosphère extérieure.

4. Article selon l'une quelconque des revendications précédentes, **dans lequel** le revêtement (7) est exclusivement en un matériau métallique.

5. Article selon l'une quelconque des revendications précédentes, **dans lequel** le métal est du titane ou de l'aluminium ou du cuivre.

6. Article selon l'une quelconque des revendications précédentes, **dans lequel** le revêtement est appliqué sous la forme d'une bande (14) ayant une largeur couvrant une zone d'un bord d'attaque (1) s'étendant entre des points de stagnation de bord d'attaque (SP1) d'angle d'incidence bas et points de stagnation de bord d'attaque (SP2) d'angle d'incidence élevé.

7. Article selon l'une quelconque des revendications précédentes, **dans lequel** le revêtement (7) est appliqué sous la forme d'une bande ayant une largeur (w) au moins couvrant une zone du bord d'attaque s'étendant entre des points de stagnation de bord d'attaque (SP3) d'angle d'incidence zéro et essentiellement une distance plus loin dans le sens de la corde des points de stagnation de bord d'attaque (SP2) d'angle d'incidence élevé.

8. Article selon l'une quelconque des revendications précédentes, **dans lequel** le revêtement (7) s'étend essentiellement sur l'article entier (3).

9. Procédé d'application d'un revêtement résistant à l'érosion (7) comprenant un matériau métallique sur une peau composite (5) d'un article aérien (3), dont le composite peut contenir de l'humidité pendant l'utilisation de l'article (3), l'article aérien (3) comprenant en outre un bord d'attaque (1) faisant face au flux d'air (a) pendant l'utilisation de l'article aérien (3, 4) et comprenant une surface aérodynamique (9), le procédé **comprenant les étapes consistant** à :
- fournir le matériau de revêtement résistant à l'érosion (7) présentant une porosité prédéterminée si bien qu'un transport d'humidité (MT) pendant ladite utilisation est possible de la peau composite (5) à la surface aérodynamique (9) du revêtement (7),
appliquer le matériau de revêtement résistant à l'érosion (45) sur la peau composite (5) sur une zone sélectionnée de l'article (3) ;
dans lequel la porosité du revêtement (7) est plus faible dans des zones de l'article (3, 4) rencontrant le flux d'air (a), que dans les zones où la surface aérodynamique (9) l'article (3, 4) a son extension suivant le courant d'air (a) lors de ladite utilisation ;
- polir la surface extérieure (9) du revêtement (7) de manière à obtenir une surface aérodynamique lisse.

10. Procédé selon la revendication 9, **dans lequel** l'étape de fourniture du matériau de revêtement résistant à l'érosion (45) présentant ladite porosité prédéterminée est effectuée simultanément à l'étape d'application du matériau (45) sur la peau composite (5).

11. Procédé selon la revendication 9 ou 10, **dans lequel** l'étape d'application du matériau (45) est réalisée par le revêtement par pulvérisation thermique, tel qu'un dépôt par pulvérisation de plasma.

12. Procédé selon la revendication 9 ou 10, **dans lequel** l'étape d'application du matériau (45) est réalisée par dépôt en phase vapeur, tel qu'un dépôt par pulvérisation cathodique.

13. Procédé selon l'une quelconque des revendications précédentes, **dans lequel le** procédé comprend une étape de fourniture d'un évidement (21) dans la peau composite (5) pour recevoir le revêtement (7), l'évidement étant fourni en comprimant une couche (77)) contre une surface de formage (72) d'un outil de formage (70), ladite surface (72) présentant un film (80) ou une autre partie saillante (74).

14. Procédé selon l'une quelconque des revendications précédentes, **dans lequel le** film est appliqué sur la couche (77) pour former l'évidement (21).

15. Utilisation d'un article aérien selon l'une quelconque des revendications 1 à 8 pour servir de partie d'un système de protection contre la foudre, d'un système antigivrage / dégivrage ou d'un système de génération de plasma.
